# EUROPEAN PATENT APPLICATION

(11) **EP 4 525 563 A1**
(43) Date of publication of application: **19.03.2025**
(21) Application number: 23197113.6
(22) Date of filing: 13.09.2023
(51) Int. Cl.: H05K 3/02, H05K 1/03

(54) **LARGE PRINTED CIRCUIT BOARDS FOR RF ROTARY JOINTS**

(71) Applicant: Schleifring GmbH, 82256 Fürstenfeldbruck (DE)
(72) Inventor: Ruckdäschel, Holger, 95447 Bayreuth (DE); Scherzer, Tim, 95447 Bayreuth (DE)
(74) Representative: Lohr, Jöstingmeier & Partner

(57) **Abstract**

A copper clad laminate has at least a first copper sheet layer 340, and a second copper sheet layer 350 laminated on opposing sides of a dielectric layer comprising syndiotactic polystyrene 310.

## Description

### Field of the invention

The invention relates to printed circuit boards which can be manufactured in large sizes, and which may be used in RF rotary joints for data rates above 10 Gbit/s. Another aspect relates to RF rotary joints using such printed circuit boards.

### Description of the related art

Printed Circuit Boards (PCBs) play a crucial role in RF rotary joints, especially in applications that require the transmission of radio frequency (RF) signals between rotating and stationary components. RF rotary joints are used in various systems, such as CT scanners, radar systems, satellite communication systems, antenna arrays, and more, where continuous and reliable RF signal transmission is required even as the components rotate relative to each other.

RF signals are sensitive to factors like impedance mismatches, reflections, and signal degradation. PCBs have to provide controlled and consistent geometries of the traces and the dielectric material, allowing for precise impedance matching and minimizing signal losses as the RF signal passes through the joint. This helps maintain signal integrity and prevents distortion.

PCB materials can be chosen specifically for their dielectric properties, which impact the performance of RF signals at higher frequencies. Materials with low dielectric constants and low dielectric loss are preferred for RF applications as they reduce signal propagation delays and minimize signal loss.

Low loss PCB materials may include PTFE or ceramic materials. Both are expensive and require complex processing. PTFE may cause environmental issues and therefore may be avoided for future projects. Ceramic materials are comparatively stiff and can hardly be adapted to different diameters of rotary joints. PTFE shows low adhesion which requires a higher surface roughness of the copper layer in order to in order to obtain sufficient adhesion. Alternative materials like a cross-linked polyethylene as disclosed in US 2002/0004125 A1 softens at higher temperature and lead to a change of the dielectric properties of the PCB.

Known PCB manufacturing processes are limited to less than 48" or 1.2m per dimension, as this is sufficient for normal PCB batches carrying electronic circuitry. Availability of longer substrates is very rare and limited to 108" or 2.4m. For large rotary joints, like CT scanners, PCBs may be needed covering a circumference of up to 5m. Further, material consistency on such large lengths is much more important than on small PCBs, as signal errors accumulate over such large lengths.

### Summary of the invention

The problem to be solved by the invention is to provide a PCB (Printed Circuit Board) and PCB material which is suitable for RF applications above 1 GHz or above 10 GHz providing low dielectric losses at these frequencies. The PCB should be economically friendly, easy to manufacture and provide constant and reproducible electrical parameters. It should be manufacturable in large sizes for large rotary joint diameters and with a high material consistency. The material should be bendable with a radius of about 0.5m.

Solutions of the problem are described in the independent claims. The dependent claims relate to further improvements of the invention.

In an embodiment, a copper claid laminate (CCL), which may be a printed circuit board substrate includes a pair of copper sheet layers laminated on opposing sides of a layer of dielectric material. There may also be multiple layers for a multilayer PCB. The dielectric material includes syndiotactic polystyrene (sPS). Syndiotactic polystyrene is a specific type of polystyrene where the styrene monomer units are arranged in a regular, alternating pattern along the polymer chain. It has higher heat resistance, better chemical resistance, and improved dimensional stability. It also tends to have higher stiffness and strength, making it suitable for applications requiring more robust properties. But most important, syndiotactic polystyrene has excellent dielectric properties at high frequencies (er<= 2,4, tan delta<=0,0003), which are close to PTFE and PTFE based substrates (er<= 2,2, tan delta<=0,0009). Therefore, it is best suited for applications which transfer RF signals at high frequencies, e.g., above 10 GHz. It is a perfect basis for strip lines or microstrips, or differential lines or waveguides, which may all be used for contactless high speed data transmission.

Alternative material like hydrocarbon/ceramics (er<= 3,5, tan delta<=0,0035) reenforced with woven glass shows higher losses and are therefore of limited use at high frequencies.

This printed circuit board substrate is better bendable than other known printed circuit board substrates, e.g., comprising PTFE or FR4 or other common materials. Here, the dielectric material can be deformed homogenously over a long length (e.g., more than 1m) to avoid variations in thickness and homogeneity. There must not appear any cracks or voids, as these would largely affect the dielectric properties and therefore signal transmission. Typically, the dielectric constant should vary no less than 10%, 5% or 2% over a length of 1m at a bending radius which is more than 100 times the thickness of the dielectric layer. The thickness of such PCBs typically is approximately 1.5 mm but can range from 0.2mm to 5mm. The copper sheets typically have a thickness of 9 to 35µm, copper can be etched thinner or copper can be added in a galvanic process. Generally, in applications of contactless data links, having long lengths of a printed circuit board, which may be more than 1m and up to 3-8m, a constant characteristic impedance over the length is most important. If there are parallel and differentially driven lines, it is of utmost importance that both lines are symmetrical and have exactly the same characteristics. This can only be achieved with a very high material homogeneity and consistency of the dielectric material together with very low geometrical tolerances of the substrate and a later PCB. Material consistency refers to the uniformity and predictability of properties within a material. With sPS, an excellent consistency of dielectric properties (dielectric constant and losses) which primarily define the RF properties may be achieved. Tests have shown that at least the consistency of RF characteristics of sPS is higher than with other materials.

In the field of rotary joints, the printed circuit board is normally only bent once, when it is installed into the rotary joint. There are no multiple bends. Under multiple bends the mechanical stability and thus material homogeneity may degrade. Further, the thermoplastic material of sPS allows bending the printed circuit board in a heated state, which makes the printed circuit board more flexible. It may e.g., be heated at a temperature between 100°C and 150°C before bending. Such a bending may lead to a plastic deformation, e.g., that the printed circuit board remains in the bent or curved state. Further, multiple substrates may be welded together. This provides a strong connection, which may help to make a closed ring for rotary joints.

sPS is more economically friendly than PTFE, as it may at least slowly degrade biologically, whereas PTFE never degrades. sPS based materials can easily be recycled by melting. Therefore, separation from the copper components can be easily done. Further, the energy required for producing a sPS material is about 30% of the energy required for a PTFE material.

Materials like FR4 degrade with their RF characteristics as they absorb a certain amount of water. Water has a very high dielectric constant of about 50 at frequencies above 10 GHz and high losses. Therefore, water absorption is highly unwanted as it leads to a significant degradation of the printed circuit board. sPS has a very low absorption of water and therefore avoids water-based degradation.

Flammability tests of the substrate based on sPS have shown sufficient robustness for most industrial and medical applications. Although PTFE and FR4 have a lower ignitability, specifically, PTFE produces highly toxic fumes when burning. The flammability of substrates based on sPS may be further improved by adding flame retardants to fulfill flammability requirements by slowing down the spread of flames and reducing smoke generation during combustion.

Syndiotactic polystyrene's (sPS) regular molecular structure can make it more challenging to process compared to regular polystyrene (PS). Specialized processing techniques may be required to achieve the desired properties. Normally, sPS is only processed by injection molding. All currently available substrates, whether based on thermosets (FR4) or PTFE or hydrocarbon are laminated in pieces and thus have limited dimensions. The printed circuit board substrate based on sPS may be manufactured by a continuous extrusion process, which is very efficient, produces a constant quality and allows to produce large lengths of substrate, which are required for large rotary joints, e.g., in CT scanners. The length may well exceed the current limit of 108" for commercially available substrates or laminates. Further, the extrusion process may allow to produce bent substrates which may be adapted to a later used radius or curvature. This allows to produce tension free substrates.

sPS is best suited for applications in CT scanners, as it has a comparatively high resistance against X-rays, which is far better than PTFE.

In an embodiment, a blend with PPE (polyphenylene ether) (Poly(oxy-2,6-dimethyl-1 ,4-phenylen), an amorphous high-performance plastic, simplifies the extrusion process, as it provides a more dimensionally stable extrusion with a wider thermal process window. It further increases the temperature dimensional stability of the substrate. Further, flame resistance is increased by the inherent flame-retardant properties of PPE. A disadvantage may be a higher dielectric constant and higher dielectric losses. Specifically, with the method described below, a very consistent material with highly constant electrical properties over large lengths may be made. If a blend of sPS and PPE is used PPE may be in the range of 1 to 50% of the weight of the granules that become part of the compound.

In an embodiment, the dielectric layer may comprise at least one filler of boron nitride, and talc, and glass hollow spheres, and quartz, and fused silica. The boron nitride may be of hexagonal or cubic structure, hexagonal boron nitride is preferred because of its better thermal conductivity and lower hardness and thus better processability.

Boron nitride is a thermally and chemically resistant refractory compound of boron and nitrogen with the chemical formula BN. BN increases the dielectric constant of the material over sPS, but significantly lowers thermal expansion and increases mechanical strength. Due to its high thermal conductivity, heat dissipationof the PCB may be improved but increasing the dielectric constant less then ceramic fillers do.

Talc (Mg3H2(SiO3)4(Mg3H2(SiO3)4 is a clay mineral, composed of hydrated magnesium silicate. It has a slightly higher dielectric constant than sPS, such that the total dielectric constant increases. But Talc increases the mechanical stability of sPS and therefore improves mechanical characteristics and processability.

Glass hollow spheres or glass microspheres add mechanical strength. Hollow spheres lower the dielectric constant but have to have small dimensions ( e.g., D50 < 25 µm and D95 < 50 µm in order not to inhibit the THT (through hole technology) process of plated through holes where copper is plated to the side walls of a drilled hole to connect copper tracks as well as fabrication of vias that electrically connect both copper clad sides of the substrate material.

Glass might be added as short fibers, also one or more sheets of woven glass may act as filler.

Quartz is a hard, crystalline mineral composed of silica (SiO₂, silicon dioxide). It also increases mechanical strength. Fused silica is silica of an amorphous structure.

Total filler content may be up to 50% of the volume, typically shared between two fillers each in the range of 10 to 20%.

Further a flame retardant may be added to improve flame resistance. Also, filler content improves flammability because the content of the thermoplastics sPS and PPE in the substrate is reduced and the fillers mentioned are non flammable.

In an embodiment, a printed circuit board includes a printed circuit board substrate according to any of the previous claims. The printed circuit board may include at least one antenna structure or waveguide.

In an embodiment, a contactless data link comprises a printed circuit board according to the previous claim. The contactless data link may have a circular shape.

In an embodiment, a CT scanner comprises a contactless data link as described herein. The contactless data link may have a circular shape and may be oriented axially or radially.

A method of copper lamination and production of the finished printed circuit board substrate called copper clad laminate (CCL) may be performed by a combination of a single-screw extruder, an in-situ lamination tool and a calender. For compounding, the sPS granules or the premixed blend of sPS PPE granules may be initially melted and mixed including at least one of several fillers and flame retardant and fed to the extruder. The compound may be formed into strands via nozzles and cooled in air or water, then cut into sections called granules for later processing by being melted and extruded again. Alternatively the compound might be used directly when still melted by beeing pressed through a nozzle by the extruder. Two sheets of copper material are fed essentially in parallel on both sides of a slot shaped nozzle having a width corresponding to the width of the copper sheets and which may have a height corresponding to the thickness of the substrate. Anyway, the height of the nozzle may be smaller or larger than the distance. The compound is plasticized and again mixed by the extruder and then fed to the nozzle, distributing the material over the width of the copper sheet material. At the exit, the extrudate is laminated with a copper layer on both sides. The substrate may be fed through a calender to calibrate its thickness and to provide an even surface, specifically over longer sections of the substrate. A compounder may be used instead of the extruder or added to the extruder.

In addition, woven glass might be fed essentially parallel on one or both sides of the slot shaped nozzle to become part of the substrate and act as filler and strengthen the substrate against lateral forces. Also, in a first step, woven glass may be added to the substrate and in a later step the copper layers may be added.

This method is a continuous process, which can be used for large substrate lengths. The method requires a thermoplastic material as dielectric, which can be extruded, such as sPS. The continuous process guarantees constant electrical characteristics over larger lengths e.g. exceeding 108" compared to a process where individual pieces of substrate are manufactured sequentially.

The extrusion allows to produce different sizes or thicknesses of the dielectric layer without severe modification of the lamination device. For adjusting and/or changing the thickness of the dielectric layer, only either an extrusion slit die width and/or a distance between the copper sheets may be adjusted, e.g., by adjusting the distance between rolls guiding and/or holding the copper sheets. Further adjustment may be made by adjusting the calender.

The extrusion also allows to produce curved substrates, which are already adapted to a curve radius as needed in a later application, e.g., a rotary joint.

As sPS is known as a dielectric material which is used for injection molding parts, it would not be considered as a suitable material for PCBs. But its excellent RF characteristics and specifically its homogeneity and unexpected material consistency at high frequencies make it a perfect basis for long RF PCBs which can be used for waveguide and contactless data links.

The substrate with laminated copper sheets (the laminate) can be processed to a PCB by transferring a layout of an electric circuitry design to the laminate, etching away parts of the copper so that the remaining copper forms tracks and microstrips. Through-holes may be drilled through the PCB stack of copper sheets and dielectric, non-plated holes may serve for mechanical mounting purposes, plated holes may connect copper tracks of both sides. Solder stop may be applied to allow reflow soldering. During the reflow process the PCB with solder paste and components placed may be heated to 250C for a short time. Thereby connecting the components and tracks to an electric circuit.

A sPS based substrate might be laminated to an FR4 preetched board to serve as additional layer with betterRF properties and be processed to a PCB as mentioned above, the PCB profiting from the FR4 mechanical properties, e.g. for a backplane application.

### Description of Drawings

In the following the invention will be described by way of example, without limitation of the general inventive concept, on examples of embodiment with reference to the drawings.
Figure 1 shows a printed circuit board substrate in a side view.
Figure 2 shows a printed circuit board in a side view.
Figure 3 shows a front view of a printed circuit board.
Figure 4 shows a top view of the previous figure.
Figure 5 shows a modified waveguide section.
Figure 6 shows a bent waveguide section.
Figure 7 shows another embodiment of a bent waveguide section.
Figure 8 shows schematically a CT (Computed Tomography) scanner gantry.
Figure 9 shows by example a laminator.

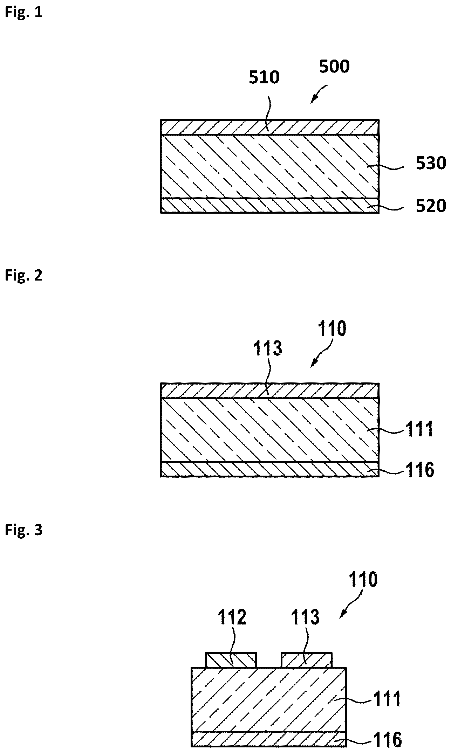

In figure 1 a printed circuit board substrate 500 is shown in a side view. A first copper sheet layer 510 and a second copper sheet layer 520 are laminated on opposing sides of a dielectric layer 530 comprising syndiotactic polystyrene (sPS). In figure 2 a printed circuit board 110 is shown in a side view. It is based on a printed circuit board substrate with shaped conductors out of the copper layers. A layer of dielectric material 111 has a first copper layer 113 and a second copper layer 116 opposing thereto.

Figure 3 shows a front view of a printed circuit board 110, which may be used for contactless data transfer, e.g., in a CT scanner. Such or similar embodiments may also be called waveguide because they are suitable for guiding electromagnetic waves. Here, two elongate conductors 112, 113 are formed out of the first copper layer 113. These conductors are similar to strip lines or microstrips (which may also be used for data transmission). Actually, a differential signal driven over two parallel lines performs better for high-speed contactless data transmission.

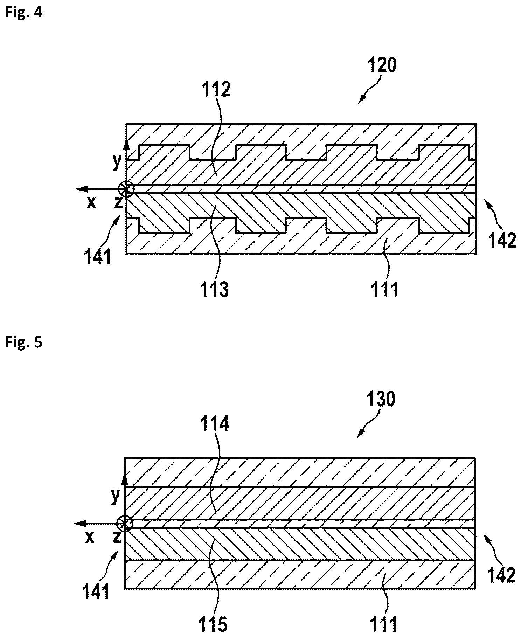

Figure 4 shows a top view of the previous figure. 22 shows an embodiment of a waveguide section 120 having elongate conductors 112, 113 which have a specific meander-shaped pattern. Such a pattern provides a higher noise immunity compared to microstrip lines. Basically, such a waveguide section may have a first end section 141 and a second end section 142 opposing thereto. Further, a coordinate system is shown with an x-direction from the right side of the drawing to the left side, a y-direction from the center to the top of the drawing as shown in this Figure, and a z-direction pointing into the drawing plane.

Figure 5 shows a modified waveguide section 130 with microstrip conductors 114, 115.

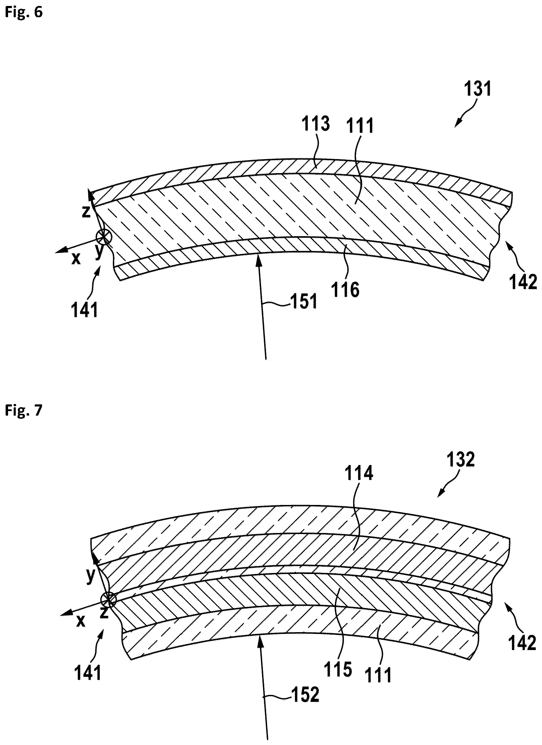

Figure 6 shows a bent waveguide section. Here, waveguide section 131 is bent with a radius 151 in an x-z-plane, such that the elongate conductors are at an outside of a cylinder shape forming by bending. In an alternate embodiment, bending may be otherwise, such that elongate conductors are at the inner side. Here, the layer of dielectric material must be deformed homogenously over a long length (e.g., more than 1m) to avoid variations in thickness and homogeneity. There must not appear any cracks or voids, as these would largely affect the dielectric properties and therefore signal transmission.

Figure 7 shows another embodiment of a bent waveguide section 132. Here, the waveguide section is bent on a radius 152 in an x-y-plane, forming a disk-shaped embodiment, where the elongate conductors are on one side of the disk. Also here, a homogenous deformation of the layer of dielectric material is essential.

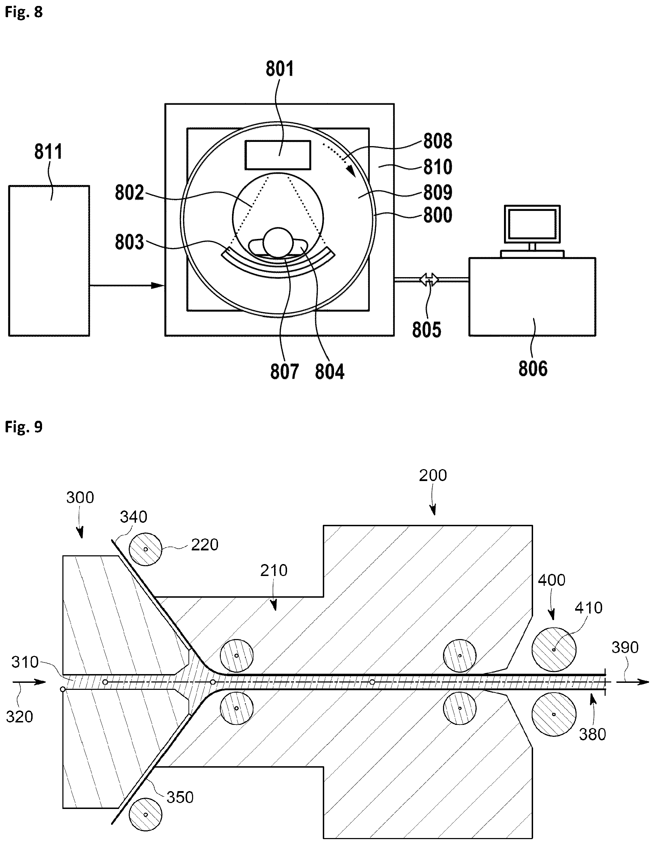

Figure 8 shows schematically a CT (Computed Tomography) scanner gantry. The stationary part is suspended within a massive frame 810. The rotating part 809 of the gantry is rotatably mounted with respect to the stationary part and rotates along the rotation direction 808. It supports an X-ray tube 801 configured to generate an X-ray beam 802 that radiates through a patient 804 lying on a table 807 and which is intercepted by a detector 803 and converted to electrical signals and imaging data thereof. Electrical power from power supply unit 811 may be transmitted by a slipring (not shown) to the rotating part. The data obtained by the detector 803 are transmitted via contactless data link 800 or contactless rotary joint to an evaluation unit 806 by means of a data bus or network 805.

Figure 9 shows by example schematically a laminator 200 together with an extruder 300 for making a printed circuit board. It has a body 210 for holding a plurality of rollers 220 which guide copper sheets 340, 350 and compress the substrate 380. A plasticized sPS material 310 flows in direction 320 through an extrusion nozzle 300 and is laminated with the copper sheets 340, 350 to form a substrate 380 moving in direction 390. A calender 400 including opposing rollers 410 may be provided to calibrate the thickness of the substrate 380. Behind the calender, there may be a cooling unit (not shown).

### List of reference numerals

- 110: printed circuit board
- 111: layer of dielectric material
- 112, 113: conductors of first copper layer
- 114, 115: elongate conductors as microstrip conductors
- 116: second copper layer
- 120: waveguide section
- 130: waveguide section
- 131: waveguide section
- 132: waveguide section
- 141: first end section
- 142: second end section
- 151: radius in x-z plane
- 152: radius in x-y plane
- 200: laminator
- 210: laminator unit
- 220: rollers
- 300: extrusion nozzle
- 310: plasticized sPS material
- 320: direction of sPS flow
- 340, 350: copper sheet
- 380: substrate
- 390: direction of sustrate movement
- 400: calender
- 410: calender rollers
- 500: printed circuit board substrate
- 510: first copper sheet layer
- 520: second copper sheet layer
- 530: dielectric layer comprising syndiotactic polystyrene (sPS)
- 800: contactless rotary joint
- 801: x-ray tube
- 802: x-ray beam
- 803: x-ray detector
- 804: patient
- 805: network
- 806: evaluation unit
- 807: patient table
- 808: rotation direction
- 809: rotating part
- 810: frame
- 811: power supply unit

## Claims

1. A copper claid laminate (500) comprising at least a first copper sheet layer (510), a second copper sheet layer (520) laminated on opposing sides of a dielectric layer (530) comprising syndiotactic polystyrene (sPS).

2. A copper claid laminate (500) according to the previous claim
**characterized in, that**
the dielectric layer (530) further comprises a blend of syndiotactic polystyrene with polyphenylene ether.

3. A copper claid laminate (500) according to the previous claim
**characterized in, that**
the dielectric layer (530) comprises a filler further comprising at least one of boron nitride, talc, glass fibers, glass hollow spheres, quartz, and fused silica.

4. A printed circuit board (110) comprising a copper claid laminate (500) according to any of the previous claims.

5. A contactless data link comprising a printed circuit board (110) according to the previous claim.

6. A CT scanner comprising a contactless data link according to the previous claim.

7. A method of manufacturing a copper claid laminate according to any of claims 1 to 6 including the steps of:
- mixing a compound of sPS optionally blended with PPE and Filler and flame retardantmaterial,
- feeding of two sheets of copper material in parallel on both sides of a slot shaped nozzle, the nozzle having a width corresponding to the width of the copper sheets,
- heating and plasticizing the compound to form material of the dielectric layer by an extruder,
- feeding the material to the nozzle and distributing the material over the width of the copper sheet material.

8. A method of manufacturing a copper claid laminate according to the previous claim, further including the steps of:
feeding of the substrate through a calender to calibrate its thickness and to provide an even surface.

9. A method of manufacturing a copper claid laminate according to the previous claim, further including the steps of:
feeding of woven glass in parallel on both sides of the slot shaped nozzle into the plasticized material prior to the step of copper foil feeding to become part of the dielectric layer.
